# EUROPEAN PATENT SPECIFICATION

(11) **EP 0 597 511 B1**
(45) Date of publication and mention of the grant of the patent: **07.04.1999**
(21) Application number: 93202814.5
(22) Date of filing: 04.10.1993
(51) Int. Cl.: H03M 13/00

(54) **Method of correcting errors and erasures in digital information, and device suitable for carrying out the method**
Verfahren für Fehler und Löschungskorrektur in digitaler Information und geeignete Vorrichtung zur Durchführung des Verfahrens
Méthode de correction d'erreurs et d'éffacements d'information digitals, et dispositif approprié à la mise en oeuvre du procédé

(30) Priority: 09.10.1992 EP 92203104
(43) Date of publication of application: 18.05.1994
(73) Proprietor: Koninklijke Philips Electronics N.V., 5621 BA Eindhoven (NL)
(72) Inventor: Arts, Petrus Henricus Marie, NL-5656 AA Eindhoven (NL)
(74) Representative: Peters, Rudolf Johannes

(56) References cited:
- EP-A- 0 075 985
- EP-A- 0 155 038
- EP-A- 0 240 363
- EP-A- 0 296 828
- GB-A- 2 205 423
- US-A- 4 020 461
- IEEE TRANSACTIONS ON INFORMATION THEORY, vol. 36, no. 4, July 1990 NEW YORK US, pages 890-895, XP 000133759 PATRICK STEVENS 'On decoding of unequal error protection product codes'
- PATENT ABSTRACTS OF JAPAN vol. 5 no. 78 (E-58) [750] ,22 May 1981 & JP-A-56 025853 (MITSUBISHI DENKI K.K.) 12 March 1981,
- PATENT ABSTRACTS OF JAPAN vol. 12 no. 153 (E-607) ,11 May 1988 & JP-A-62 266926 (TOSHIBA CORPORATION) 19 November 1987,

## Description

The invention relates to a method of correcting errors and erasures in digital information subdivided into code words in accordance with an error correction code with minimum distance d, which code words contain data symbols and redundant symbols, in theory it being possible to correct at the most Tmax errors, at the most T errors being corrected. The invention also relates to a device suitable for carrying out the method.

A method and device of the kind set forth are described in Philips Technical Review, Vol. 40, 1982, No. 6, pp. 166-173. Digital information representing, for example sound (sampled, quantized, coded and modulated audio signals) is subdivided into code words in conformity with an error correction code (for example, a Reed-Solomon code), which code words consist of data symbols (containing the actual information) and redundant symbols (added in accordance with the rules of the error correction code in order to enable error correction and detection). An incorrect symbol (*i.e.* a symbol to be corrected) whose position in the code word is known is referred to as an erasure. An incorrect symbol in a code word whose exact value and position in the code word are unknown, is referred to as an error. The term "error correction operation" may include the finding of the correct value of one or more erasure symbols. The error correction code used has a minimum distance, say d. In that case a number of t errors and a number of e erasures can be corrected per code word, provided that the equation 2t+e<d is satisfied. The largest number of errors that can be corrected in theory, say Tmax, equals (d-1)/2 for d odd and (d-2)/2 for d even. Therefore, 2Tmax = (d-1)-(d-1)MODULO 2. The method utilizes known means (the input being the code word and erasure data, *i.e.* the number and the positions of the erasures in the code word) for correcting at the most T errors, the value of T being smaller than or equal to Tmax. The complexity of the means used for correcting at the most T errors (the known erco circuit) is highly dependent on the value of T, because the magnitude and difficulty of the calculations to be performed are a sharply rising function of T. Therefore, the means become very complex for high values of T.

It is *inter alia* an object of the invention to provide a method of correcting at the most T errors while utilizing means (known *per se*) for correcting at the most T-1 errors. To this end, a method in accordance with the invention is characterized in that per code word the correction involves the following steps:
1. imposing an erasure indication for each symbol of a sub-set of the symbols;
2. executing a complete error correction operation by means of said imposed erasure(s);
3. verifying correctness of this complete error correction operation;
4. repeating the steps 1, 2 and 3 for different sub-sets until either said verifying indicates said correctness or until all relevant sub-sets have been subjected to the steps 1, 2 and 3.
Thus, by successively performing a correction for at the most T-1 errors, ultimately a correction for T errors will also be performed, without utilizing the customary, more complex erco circuit. This is attractive for applications of error correction codes where the most complex desired correction (T errors) occurs comparatively rarely and adequate correction time is available.

A device suitable for carrying out the method in accordance with the invention is characterized in that it comprises means for receiving a code word, means for receiving erasure data, means for correcting at the most T-1 errors, and means which are activated when the number of erasures is smaller than or equal to 2(Tmax- T)+(d-1)MODULO 2 and a first correction by means of the means for correcting at the most T-1 errors was not successful, in order to define successively each time at least 1 symbol of the code word as a fictitious erasure and to execute, given the erasures e and the fictitious erasure(s), a further correction by way of the means for correcting at the most T-1 errors until substantially all constituent symbols of the code word have had their turn. The invention thus provides a less complex device for correcting as many errors and erasures in digital information as known devices.
Fig. 1 shows a flow chart of a method in accordance with the invention;
Fig. 2 shows an embodiment of a device in accordance with the invention.

Digital information representing, for example sound (sampled, quantized, encoded and modulated audio signals) can be subdivided, in conformity with an error correction code (for example, a Reed-Solomon code), into code words consisting of data symbols (containing the actual information) and redundant symbols (added in conformity with the rules of the error correction code so as to enable error correction and detection). An incorrect symbol (that is to say a symbol to be corrected) whose position in the code word is known is referred to as an erasure. An incorrect symbol whose value and position in the code word are unknown is referred to as an error. The error correction code used has a minimum distance, say d. In that case a number of t errors and a number of e erasures can be corrected per code word, provided that the equation 2t+e<d is satisfied. The largest number of errors that can be corrected in theory, say Tmax), equals (d-1)/2 for d odd and (d-2)/2 for d even. Therefore, 2Tmax = (d-1)-(d- 1)MODULO 2 . For more background information on error correction reference is made to "The Art of Digital Audio", J. Watkinson, Focal Press, London, 1988, chapter 7, pp. 201-247.

In digital cassette recorders (DCC) digital information is protected by way of error correction codes. Different Reed-Solomon codes are used for data channels and an auxiliary channel. A code word consists of 24 8-bit symbols. For the data channels use is made of a product code composed of a C1 code (RS(24,20,5) over GF(256)) and a C2 code (RS(32,26,7) over GF(256)). For the auxiliary channel a single code RS(24,18,7) over GF(256) is used. All said codes can be decoded by the same erco circuit. The maximum number of errors that can be corrected for the code C1 is 2. In the correction strategy used for the code C2, it does not make sense to perform a correction for 3 errors. This would merely result in a negligibly small improvement of performance. However, it has been found useful to perform a correction for 3 errors for the auxiliary channel. The number of corrections to be executed for the auxiliary channel amounts to only a fraction of the number of corrections to be executed for the codes C1 and C2. Therefore, in this application ample correction time is available to execute the 3-error correction in accordance with the invention by repeatedly executing the 2-error correction. This will be described in detail hereinafter.

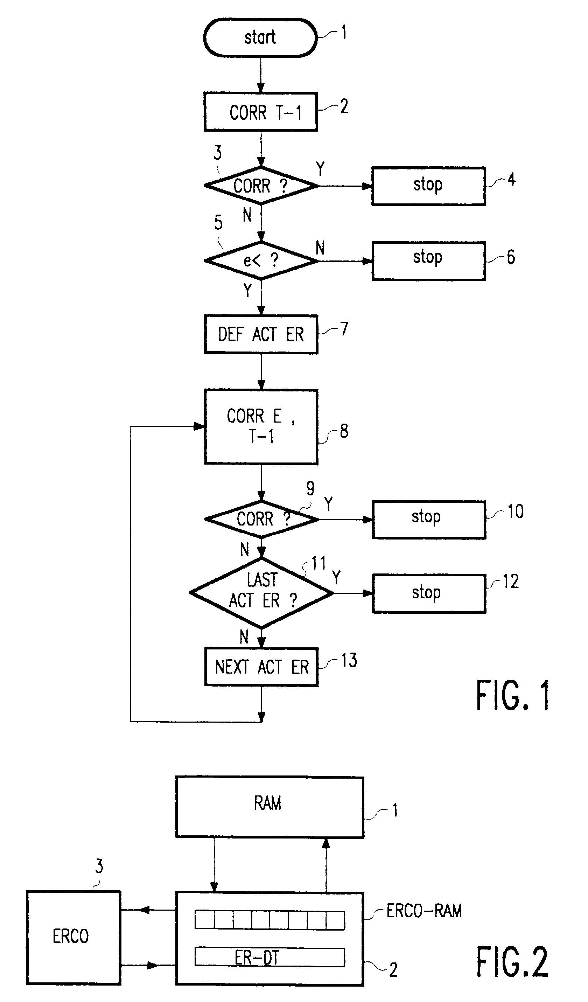

Fig. 1 shows a flow chart of a method in accordance with the invention. The method utilizes known means (their input being the code word and erasure data, that is to say the number and the positions of the erasures in the code word) for the correction of at the most T errors, the value of T being smaller than or equal to Tmax.

The method starts in block 1; the input at that instant is formed by the code word to be corrected and the erasures in this code word, *i.e.* the positions in the code word where incorrect symbols are present. In accordance with the invention, at the most T errors per code word are corrected. When T is smaller than Tmax, the remaining parity symbols can be used, for example for an additional detection margin. In block 2 a correction step is executed by means of a known erco circuit for correcting at the most T-1 errors. Subsequently, in block 3 it is verified whether the correction step was successful. If so, the method proceeds to block 4: stop; evidently, the code word contained at the most T-1 errors which could all be corrected. If not, the method proceeds to block 5: verification whether the number of erasures (note that this number is already known in block 1) is smaller than or equal to 2(Tmax-T)+(d-1)MODULO 2. Thus, for odd values of d it is verified whether the number of erasures is smaller than or equal to 2(Tmax-T); for even values of d it is verified whether the number of erasures is smaller than or equal to 2(Tmax-T)+1. If not, the method proceeds to block 6: stop; evidently, the code word cannot be corrected, because {2T+e} > (2T+2(Tmax-T)+(d-1)MODULO 2} = {2Tmax+(d-1)MODULO 2} = {d-1}, so that it no longer holds that 2T+e<d; in accordance with this method this error pattern cannot be corrected.

The following example is given for the purpose of illustration: assume that the minimum distance d equals 9; in that case the largest number of errors that can be corrected in theory equals Tmax = 4. Assume that at the most T = 3 errors need be corrected; the remaining parity symbols then serve, for example as an additional detection margin. In accordance with the method, at the most T = 3 errors are corrected by means of an erco circuit which is suitable for the correction of at the most T-1 = 2 errors per code word. First a correction step for 2 errors is performed in block 2, after which it is checked in block 3 whether this correction step was successful. If so, the operation is finished: the code word contained at the most 2 errors and at the most 4 erasures. If not, in block 5 it is checked whether the number of erasures is smaller than or equal to 2(4-3)+0 = 2. This is because in that case it makes sense to attempt a correction for 3 errors. When the number of erasures is greater than 2(Tmax-T)+(d-1)MODULO 2, 2T+e> =d, so that according to the method the code word cannot be corrected.

When the number of erasures is small enough, the method proceeds to block 7. A first symbol of the code word to be corrected is defined as a fictitious erasure. In that case a correction step is performed in block 8 by means of the means for correcting at the most T-1 errors, given the known erasures (evidently, this number may be zero) and the fictitious erasure. In block 9 it is verified whether the correction step was successful. If so, the method proceeds to block 10: stop; evidently, the code word T contained errors, one of which was located in the position of the fictitious erasure, so that the correction in accordance with the invention has been successful. If not, the method proceeds to block 11: verification whether all symbols of the code word have had their turn as a fictitious erasure. If so, the method proceeds to block 12: stop; evidently, the code word contained more than T errors, so that it cannot be corrected in accordance with the method. If not, the method proceeds to block 13: define a next symbol of the code word to be corrected as a fictitious erasure. Proceed to block 8. A correction step for T-1 errors is thus repeatedly executed, each time with given erasures and a fictitious erasure.

The iteration can be terminated already before all symbols of the code word to be corrected have had their turn as a fictitious erasure: the last T-1 correction steps in the iteration are superfluous, because in the event of T errors occurring at least one must already have been treated as a fictitious erasure before the last T-1 correction steps.

It is to be noted that, when the number of erasures is sufficiently small (block 5), it is also possible to define more than one fictitious erasure in the blocks 7 and 13, for example, each time two successive erasures. This offers the advantage that the number of iterations is then much smaller (substantially halved). A drawback could be that the risk of miscorrection increases. An example: for d=7, Tmax=3, T=3, e=0 and two fictitious erasures, it may occur that four symbols are modified by a miscorrection during a correction step for at the most T-1=2 errors. An adequate step to solve this problem is to abstain from correction when the number of symbols to be modified is greater than T.

It is also to be noted that the first correction step in block 2 of the method shown in Fig. 1 will usually be successful, because the probability of T errors will be much smaller than the probability of T-1 errors. Therefore, it is advantageous to attempt, like in Fig. 1, first a separate correction step for T-1 errors, before checking (block 5) whether it makes sense to attempt a correction for T errors.

Fig. 2 shows an embodiment of a device in accordance with the invention. An external memory 1 (for example, a RAM) contains a number of code words, each of which comprises, for example 24 symbols or bytes. The external memory 1 does not necessarily form part of the device in accordance with the invention. Under the control of a control unit (not shown), data can be exchanged with a memory 2, being the so-called erco-RAM. In the erco-RAM a code word to be corrected is stored and corrected. The corrected code word is returned to the external RAM. In the external RAM the symbols are provided with flags which are capable of assuming three different values. These flags can be represented by means of two additional bits. The following meaning is attached to the values of the flag bits:
2: the relevant symbol is an erasure;
1: the relevant symbol is not an erasure and forms part of a code word which has been found to contain at the most {2(Tmax-T)+(d- 1)MODULO 2} erasures during a first correction step and which was uncorrectable thus far;
0: the relevant symbol is not an erasure and does not belong to a code word which has been found to contain at the most {2(Tmax-T) +(d-l)MODULO 2} erasures during a first correction step and which was uncorrectable thus far.

For initialization the value 0 can be assigned to all flags.

All symbols of a code word to be corrected are transferred from the external RAM to the erco-RAM. Per symbol an additional bit is available in the erco-RAM to memorize whether the relevant symbol is an erasure. This erasure data originates, for example from a demodulator or (when a product code is used) from a decoder of a first code. Furthermore, in the erco-RAM it is also memorized whether symbols with a flag having the value 1 have arrived with a code word and whether the number of erasures in a code word is larger than {2(Tmax-T)+(d- 1)MODULO 2}. After the complete code word has been written into the erco-RAM, a correction step is executed for T-1 errors. Subsequent to this step, the code word is returned to the external RAM, the values of the returned flags being dependent on the result of the most recent correction step, on whether symbols have arrived with a flag having the value 1, and on the number of erasures as will be described hereinafter.

If the code word was correctable, all constituent symbols obtain a flag having the value 0.

If the code word was not correctable, and no symbols having a flag of value 1 have arrived and the number of erasures is not larger than {2(Tmax-T)+(d-1)MODULO 2}, the first symbol is provided with a flag having the value 2 and the other symbols with a flag having the value 1.

If the code word was not correctable and no symbols having a flag of value 1 have arrived and the number of erasures is larger than {2(Tmax-T)+(d-1)MODULO 2}, all symbols are provided with a flag of value 2.

If the code word was not correctable and symbols having a flag of value 1 have arrived, all symbols are provided with a flag of value 1, except the symbol succeeding the symbol which was an erasure according to its relevant additional bit in the erco-RAM; this symbol is provided with a flag of value 2.

Under the control of the control unit, the device executes the above procedure 25 times (for a code word having a length of 24 symbols); the error correction in accordance with the invention has then been completed: the correction for T errors has been performed by way of means for correcting at the most T-1 errors.
The result is:
- if 2T+e<d, the correction has been successful and all symbols of the code word have been provided with a flag of value 0;
- if 2T+e> =d and e <= (2(Tmax-T)+(d-1)MODULO 2}, the error pattern cannot be corrected and all symbols of the code word have been provided with a flag of value 1;
- if 2T+e> =d and e > {2(Tmax-T)+(d-1)MODULO 2}, the error pattern cannot be corrected and all symbols of the code word have been provided with a flag of value 2.

### Epilogue

In the embodiment of the invention codes are considered which are systematic at the symbol level. This restriction is not necessary. The invention can also be used for codes where a yes/no distinction between data symbols and redundant symbols is not possible. The invention can furthermore be used notably for symbols comprising several bits, for example 2, 4 or 8 bits. The invention is particularly attractive when the same hardware is to decode several codes with different minimum distances defined over the same Galois field and having respective generator polynomials, a first generator polynomial being a factor of the second generator polynomial. This is because the generator polynomial can be written as an infinite product of factors, each factor defining a zero point of the polynomial. As a result, the second generator polynomial defines a sub-code of that defined by the first generator polynomial. On the other hand, the minimum distance between code words need not be uniform over the entire space of a given code. The advantage of the invention becomes apparent notably if the iterative trial method is required only for a comparatively small fraction of the code words. The described situation is a first example thereof in which the majority of the code words belong to a code with a comparatively small minimum distance whereas only a small fraction belongs to that with the larger minimum distance. Another example is that in most cases direct decoding produces full correction, the remaining cases representing merely a small remainder. The basic idea of the invention consists in that "imposing" an erasure enables calculation of an error symbol for the relevant erasure as well as, in addition, detection of the correctness, or not, of a correction to be performed by means of the relevant error symbol. Such detection may be based on two aspects: on the one hand, in addition to said correction there may be an additional detection possibility in that the minimum distance of the code is sufficient. Even when the minimum distance is completely "used up", additional detection may be certain or probable in the event of, for example a strongly reduced Reed-Solomon code as used in all cases described. This is because the length of a code word therein is always substantially smaller than 256 symbols. Maximum distance separable codes other than Reed-Solomon codes are also known *per se*. The invention can be used with externally presented erasures, in addition to the imposed erasures or not, for example external erasures originating from a previous digital processing step or a different detection. The trial method can be stopped either after all symbols have had their turn, or when suitable correction is detected. It is to be noted in this respect that an incorrect result can be obtained even in the case of an apparently correct correction. According to the iterative trial method, all symbols can be treated in a systematic sequence. It is also possible to grant priority to given symbols on the basis of an *a priori* higher probability of these symbols being "truly" incorrect, or to exclude given symbols because they have already been externally signalled to be erasures. In given cases the described operation at the symbol level can be combined with additional steps at the bit level, for example steps against single-bit errors. The method is preferably carried out in a device which is constructed as a consumer entertainment product in which the symbols represent at least partly a stream of audio and/or video information. Notably digital audio information is susceptible to errors which are experienced to be very annoying. Applications in this respect are, for example Compact Disc Audio and derivatives, and the Digital Compact Cassette (DCC) system.

## Claims

1. A method for correcting symbol errors and symbol erasures in a code word composed of plural-bit symbols that has been encoded according to an error protection code with a predetermined symbol error correction capability, which method comprises the following steps:
1. imposing an erasure indication for each symbol of a sub-set of the symbols;
2. executing a complete error correction operation by means of said imposed erasure(s);
3. verifying correctness of this complete error correction operation;
4. repeating the steps 1, 2 and 3 for different sub-sets until either said verifying indicates said correctness or until all relevant sub-sets have been subjected to the steps 1, 2 and 3.

2. A method as claimed in Claim 1, in which step 1 is preceded by: 0. execution of an initial correction operation on a number of symbols smaller than a maximum number corresponding to said correction capability, and detection of an incorrect result of this initial correction operation.

3. A method as claimed in Claim 1 or 2, in which each sub-set uniformly contains either one symbol or two symbols.

4. A method as claimed in Claim 1, 2 or 3, utilizing a device allowing for at most an error correction smaller than said correction capability.

5. A method as claimed in any one of the Claims 1 to 4, also utilizing for said complete correction operation one or more externally presented erasures outside said sub-set.

6. A device for carrying out the method claimed in any one of the Claims 1 to 5 for correcting a code word composed of multi-bit symbols that has been encoded according to an error protection code having a predetermined symbol error correction capability, and having sequencer means for
- in a first state executing an initial correction on a number of symbols that is smaller than a maximum number corresponding to said correction capability, and detecting of an incorrect result of this initial correction operation;
- in each of a string of successor states imposing an erasure indication for each symbol of a sub-set of symbols that is unique for the successor state in question, executing a complete error correction operation by means of said imposed erasure(s), verifying correctness of this complete correction operation, and cycling through all successor states until either said verifying indicates said correctness or until all states of said string have been passed.

7. A device as claimed in Claim 6, wherein all subsets are mutually exclusive.

8. A device as claimed in Claim 6 or 7, for a code that is systematic at the symbol level.

9. A device as claimed in Claim 6, 7 or 8, which device is constructed as an apparatus for consumer entertainment, the symbols representing at least partly a stream of audio and/or video information.

10. A device as claimed in any of Claims 5 to 9, for correcting said code words interspersed at relatively rare recurrence amongst second code words at relatively common recurrence, said second code words having been encoded according to a second error protection code with lower symbol error correction capability, for which only said first state is activated.

## Patentansprüche

1. Verfahren zum Korrigieren von Symbolfehlern und Symbollöschungen in einem aus Mehrbit-Symbolen zusammengesetzten Codewort, das gemäß einem Fehlerschutzcode mit einem zuvor bestimmten Symbolfehlerkorrekturvermögen codiert worden ist, wobei das Verfahren die folgenden Schritte umfaßt:
1. Auferlegen einer Löschungsangabe für jedes Symbol einer Teilmenge der Symbole;
2. Ausführen einer vollständigen Fehlerkorrekturoperation mittels der genannten auferlegten Löschung(en);
3. Verifizieren der Korrektheit dieser vollständigen Fehlerkorrekturoperation;
4. Wiederholen der Schritte 1, 2 und 3 für unterschiedliche Teilmengen, bis entweder die genannte Verifizierung die genannte Korrektheit angibt oder bis alle relevanten Teilmengen den Schritten 1, 2 und 3 unterzogen worden sind.

2. Verfahren nach Anspruch 1, bei dem dem Schritt 1 vorausgeht:
0. Ausführen einer Anfangskorrekturoperation an einer Anzahl Symbole, die kleiner ist als eine dem genannten Korrekturvermögen entsprechende maximale Anzahl und Detektion eines nicht korrekten Ergebnisses dieser Anfangskorrekturoperation.

3. Verfahren nach Anspruch 1 oder 2, bei dem jede Teilmenge gleichermaßen entweder ein einziges Symbol oder zwei Symbole enthält.

4. Verfahren nach Anspruch 1, 2 oder 3, das eine Einrichtung nutzt, die höchstens eine Fehlerkorrektur zuläßt, die kleiner ist als das genannte Korrekturvermögen.

5. Verfahren nach einem der Ansprüche 1 bis 4, das für die genannte vollständige Korrekturoperation außerdem eine oder mehrere extern präsentierte Löschungen außerhalb der genannten Teilmenge nutzt.

6. Einrichtung zum Durchführen des Verfahrens nach einem der Ansprüche 1 bis 5 zum Korrigieren eines aus Mehrbit-Symbolen zusammengesetzten Codewortes, das gemäß einem Fehlerschutzcode mit einem zuvor bestimmten Symbolfehlerkorrekturvermögen codiert worden ist, und mit Ablaufsteuerungsmitteln, um
- in einem ersten Zustand eine Anfangskorrektur an einer Anzahl von Symbolen auszuführen, die kleiner ist als eine dem genannten Korrekturvermögen entsprechende maximale Anzahl, und um ein nicht korrektes Ergebnis dieser Anfangskorrekturoperation zu detektieren;
- in jedem aus einer Reihe von Nachfolgerzuständen eine Löschungsangabe für jedes Symbol einer Teilmenge von Symbolen aufzuerlegen, die für den betreffenden Nachfolgerzustand einmalig ist, eine vollständige Fehlerkorrekturoperation mit Hilfe der genannten auferlegten Löschung(en) auszuführen, Korrektheit dieser vollständige Korrekturoperation zu verifizieren und alle Nachfolgerzustände zyklisch zu durchlaufen, bis entweder die genannte Verifizierung die genannte Korrektheit angibt oder bis alle Zustände der genannten Reihe durchlaufen worden sind.

7. Einrichtung nach Anspruch 6, wobei alle Teilmengen einander ausschließen.

8. Einrichtung nach Anspruch 6 oder 7, für einen Code, der auf Symbolebene systematisch ist.

9. Einrichtung nach Anspruch 6, 7 oder 8, welche Einrichtung als Gerät zur Konsumentenunterhaltung ausgeführt ist, wobei die Symbole zumindest teilweise einen Strom aus Audio- und/oder Videoinformation repräsentieren.

10. Einrichtung nach einem der Ansprüche 5 bis 9, zum Korrigieren der genannten Codewörter, die mit relativ seltener Wiederholung zwischen zweiten Codewörter mit relativ häufiger Wiederholung verteilt sind, wobei die genannten zweiten Codewörter gemäß einem zweiten Fehlerschutzcode mit geringerem Symbolfehlerkorrekturvermögen codiert worden sind, für den nur der genannte erste Zustand aktiviert worden ist.

## Revendications

1. Procédé pour corriger des erreurs de symbole et des effacements de symbole dans un mot code composé de symboles à plusieurs bits qui a été encodé suivant un code de protection d'erreur présentant une capacité de correction d'erreur de symbole prédéterminée, lequel procédé comprend les étapes suivantes :
1. imposer une indication d'effacement pour chaque symbole d'un sous-jeu de symboles;
2. exécuter une opération de correction d'erreur complète au moyen dudit ou desdits effacements imposés;
3. vérifier l'exactitude de cette opération de correction d'erreur complète, et
4. répéter les étapes 1, 2 et 3 pour différents sous-jeux jusqu'à ce que soit ladite vérification indique ladite exactitude, soit jusqu'à ce que tous les sous-jeux concernés soient passés par les étapes 1, 2 et 3.

2. Procédé suivant la revendication 1, dans lequel l'étape 1 est précédée par : 0. l'exécution d'une opération de correction initiale sur un certain nombre de symboles inférieur à un nombre maximal correspondant à ladite capacité de correction, et la détection d'un résultat incorrect de cette opération de correction initiale.

3. Procédé suivant la revendication 1 ou 2, dans lequel chaque sous-jeu comprend uniformément soit un symbole, soit deux symboles.

4. Procédé suivant la revendication 1, 2 ou 3, utilisant un dispositif permettant au maximum une correction d'erreur inférieure à ladite capacité de correction.

5. Procédé suivant l'une quelconque des revendications 1 à 4, utilisant également pour ladite opération de correction complète un ou plusieurs effacements présentés par voie externe hors dudit sous-jeu.

6. Dispositif pour mettre en oeuvre le procédé revendiqué dans l'une quelconque des revendications 1 à 5 pour corriger un mot code composé de symboles à plusieurs bits, qui a été codé suivant un code de protection d'erreur présentant une capacité de correction d'erreur de symbole prédéterminée, et comportant des moyens faisant office de séquenceur pour
- dans un premier état, exécuter une correction initiale sur un certain nombre de symboles qui est inférieur à un nombre maximal correspondant à ladite capacité de correction, et détecter un résultat incorrect de cette opération de correction initiale;
- dans chaque état d'une chaîne d'états successifs, imposer une indication d'effacement pour chaque symbole d'un sous-jeu de symboles qui est unique pour l'état dans la succession en question, exécuter une opération de correction d'erreur complète au moyen dudit ou desdits effacements, vérifier l'exactitude de cette opération de correction complète, et effectuer des cycles passant par tous les états successifs jusqu'à ce que soit la vérification indique ladite exactitude soit jusqu'à tous les états de ladite chaîne aient été passés.

7. Dispositif suivant la revendication 6, dans lequel tous les sous-jeux s'excluent mutuellement.

8. Dispositif suivant la revendication 6 ou 7 pour un code qui est systématique au niveau du symbole.

9. Dispositif suivant la revendication 6, 7 ou 8, lequel dispositif est conçu comme un appareil pour le divertissement grand public, les symboles représentant au moins en partie un flux d'informations audio et/ou vidéo.

10. Dispositif suivant l'une quelconque des revendications 5 à 9, pour corriger lesdits mots code intercalés suivant une récurrence relativement rare parmi des deuxièmes mots codes suivant une récurrence relativement courante, lesdits deuxièmes mots code ayant été codés suivant un deuxième code de protection d'erreur comportant une capacité de correction d'erreur de symbole inférieure, pour laquelle seul ledit premier état est activé.
